(19) Europäisches Patentamt
European Patent Office
Office européen des brevets

(11) **EP 4 170 369 B1**

(12) **EUROPÄISCHE PATENTSCHRIFT**

(45) Veröffentlichungstag und Bekanntmachung des Hinweises auf die Patenterteilung:
**06.11.2024  Patentblatt 2024/45**

(21) Anmeldenummer: **22202053.9**

(22) Anmeldetag: **18.10.2022**

(51) Internationale Patentklassifikation (IPC):
**G01R 31/387** (2019.01)     **G01R 31/367** (2019.01)
**G01R 31/382** (2019.01)

(52) Gemeinsame Patentklassifikation (CPC):
**G01R 31/38; G01R 31/392**

(54) **VERFAHREN, COMPUTERPROGRAMMPRODUKT UND ELEKTRONISCHES GERÄT**

METHOD, COMPUTER PROGRAM PRODUCT AND ELECTRONIC DEVICE

PROCÉDÉ, PRODUIT DE PROGRAMME INFORMATIQUE ET APPAREIL ÉLECTRONIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **18.10.2021  DE 102021211717**

(43) Veröffentlichungstag der Anmeldung:
**26.04.2023  Patentblatt 2023/17**

(73) Patentinhaber: **QUNDIS GmbH
99098 Erfurt (DE)**

(72) Erfinder: **KUHN, Jens
98693 Ilmenau (DE)**

(74) Vertreter: **Liedtke & Partner Patentanwälte
Gerhart-Hauptmann-Straße 10/11
99096 Erfurt (DE)**

(56) Entgegenhaltungen:
**WO-A1-2008/082288     DE-A1- 10 158 029
US-B2- 11 073 567**

**EP 4 170 369 B1**

**Beschreibung**

Die Erfindung betrifft ein Verfahren sowie ein Computerprogrammprodukt und ein elektronisches Gerät.

Aus der DE 10 2011 113 828 A1 ist ein Verfahren zur Ermittlung des Batterieladezustands einer Batterie in einem batteriebetriebenen Gerät mit zeitlich wechselndem Stromverbrauch bekannt, bei dem die Spannung der Batterie gemessen und daraus ein Kriterium für den Batterieladezustand abgeleitet wird. Es ist vorgesehen, dass die Spannung der Batterie in mindestens zwei verschiedenen Lastzuständen oder einem ausgewählten charakteristischen Lastzustand gemessen wird. Ferner wird ein zur Durchführung des vorbeschriebenen Verfahrens eingerichtetes Verbrauchserfassungsgerät beschrieben.

Aus der DE 10 2001 010 985 A1 ist ein Verfahren sowie eine Schaltungsanordnung zur Bestimmung der Restlebensdauer einer Batterie für batteriebetriebene elektronische Geräte, bei welchem der zeitliche Verlauf der Batteriespannung und/oder der zeitliche Verlauf des Batteriestroms ab Inbetriebnahme der Batterie erfasst und abgespeichert werden, woraus die wahrscheinliche Restlebensdauer der Batterie unter Berücksichtigung spezifischer Batterieeigenschaften extrapoliert wird, wobei als weiterer Parameter zumindest der zeitliche Verlauf der Batterietemperatur in die Extrapolation mit einbezogen wird, um durch Berücksichtigung des zyklischen Verlaufs aller Parameter eine präzise Prognose der Restlebensdauer der Batterie zu treffen.

In den bekannten Verfahren werden Messungen von Strom, Spannung und Temperatur durchgeführt, die zeitlichen Verläufe dieser Messgrößen abgespeichert, um auf der Basis von Batteriemodellen den Ladezustand der Batterie zu ermitteln und eine Restlebensdauer zu berechnen.

Aus der DE 10 2018 126 673 A1 ist eine Vorrichtung mit einer Funkkommunikationseinheit und einer Batterie zur elektrischen Energieversorgung, zumindest der Funkkommunikationseinheit, umfassend eine Einheit zur Ermittlung oder Prognose eines aktuellen Batterieladezustandes und zur Einstellung einer Sendeleistung der Funkkommunikationseinheit in Abhängigkeit vom ermittelten oder prognostizierten Batterieladezustand und in Abhängigkeit von einer verbleibenden vorgegebenen Einsatzdauer der Vorrichtung bekannt. Der Batterieladezustand kann beispielsweise durch eine Messung oder mehrere Messungen ermittelt werden, beispielsweise anhand eines Spannungseinbruchs bei einer hohen Strombelastung oder auf andere Weise.

Die WO 2008/082288 A1 beschreibt ein Verfahren zur Schätzung der Lebensdauer einer Batterie in einem batteriebetriebenen Gerät sowie ein System zum Schätzen der Lebensdauer einer Batterie, ein batteriebetriebenes Gerät zur Verwendung in einem solchen System, ein zentrales Verarbeitungsgerät zur Verwendung in einem solchen System und ein Computerprogrammprodukt.

Die US 11 073 567 B2 beschreibt ein Verfahren und eine Vorrichtung zur Diagnose einer Fahrzeugbatterie. Das Fahrzeugbatterie-Diagnoseverfahren umfasst das Empfangen von Verlaufsdaten zum Batteriezustand, einschließlich Daten, die auf der Grundlage von Ladezustandsbereichen (SOC) einer Batterie und SOCs der Batterie gespeichert sind. Anschließend werden maximale Verteilungen der SOCs der Batterie auf der Grundlage der Verlaufsdaten des Batteriezustands bestimmt. Ein Zustand der Batterie wird basierend auf einer Reduktionsrate unter den maximalen Verteilungen der SOCs der Batterie basierend auf den Batteriezustandsverlaufsdaten diagnostiziert.

Die DE 101 58 029 A1 beschreibt eine Vorrichtung und Verfahren zum Bestimmen eines dynamischen Ladezustandes einer Batterie, die einem periodischen Laden und Entladen in einem System ausgesetzt ist.

Der Erfindung liegt die Aufgabe zu Grunde, ein gegenüber dem Stand der Technik verbessertes Verfahren zur Bestimmung einer Restlebensdauer einer Batterie eines elektronischen, batteriebetriebenen Gerätes sowie ein Computerprogrammprodukt und ein elektronisches Gerät anzugeben.

Die Aufgabe wird erfindungsgemäß gelöst durch ein Verfahren zur Ermittlung einer Restlebensdauer Prognose für ein batteriebetriebenes Gerät mit den Merkmalen des Anspruchs 1. Hinsichtlich des Computerprogrammprodukts wird die Aufgabe erfindungsgemäß durch die Merkmale des Anspruchs 12 gelöst und hinsichtlich des elektronischen Gerätes durch die Merkmale des Anspruchs 13 gelöst.

Vorteilhafte Ausgestaltungen der Erfindung sind Gegenstand der Unteransprüche.

Die Aufgabe wird erfindungsgemäß gelöst durch ein Verfahren zur Bestimmung einer Restlebensdauer einer Batterie eines elektronischen Gerätes, insbesondere eines batteriebetriebenen Gerätes, insbesondere eines Messgerätes mit wechselndem Stromverbrauch, wie zum Beispiel eines Verbrauchszählers mit wechselndem Stromverbrauch, wobei die Restlebensdauer anhand einer entnehmbaren Kapazität der Batterie, einer vorgegebenen Zeitdauer, zum Beispiel von einem Jahr oder Monat, einer Selbstentladung der Batterie pro vorgegebener Zeitdauer und eines mittleren Entladestroms der Batterie wie folgt bestimmt wird:

$$t_R = \frac{C_{eb}}{I_m} \cdot (1 - S_a)^{\frac{t_R}{a}} \qquad [1]$$

mit $C_{eb}$ = entnehmbare Kapazität, $S_a$ = Selbstentladung pro vorgegebene Zeitdauer (zum Beispiel ein Jahr oder ein Monat), a = vorgegebene Zeitdauer (zum Beispiel ein Jahr oder ein Monat), $I_m$ = mittlerer Entladestrom, $t_R$ = Restlebensdauer.

Vorteilhafterweise wird der mittlere Entladestrom der Batterie anhand einer Häufigkeitsverteilung einer Anzahl von, insbesondere vorgegebenen, Betriebszuständen bestimmt.

Bei der Erfassung des mittleren Entladestroms der Batterie ist es vorteilhaft, wenn dieser für unterschiedliche Betriebszustände erfasst und ausgewertet wird. Hierzu kann eine Anzahl von, insbesondere relevanten, Betriebszuständen als Betriebszustände vorgegeben werden. Beispielsweise werden als für den mittleren Entladestrom relevante Betriebszustände jene Betriebszustände vorgegeben, welche einen hohen Stromverbrauch im Betrieb des elektronischen Geräts aufweisen. Beispielsweise werden als Betriebszustand ein Messmodus, ein Rechenmodus, ein Speichermodus, ein Kommunikationsmodus, ein Sendemodus, ein Ruhemodus, ein Temperaturmodus und/oder ein Installationsmodus des elektronischen Gerätes ein Einsatzmodus des elektronischen Gerätes an einem Standort und/oder ein Umschaltmodus zwischen zwei dieser Betriebszustände vorgegeben.

Die mit der Erfindung erzielten Vorteile bestehen insbesondere darin, dass ein besonders einfaches Verfahren zur Bestimmung der Restlebensdauer der Batterie mit wenigen einfachen und insbesondere vorgebbaren Parametern gegeben ist, so dass aufwendige Messungen vermieden sind.

Für die entnehmbare Kapazität wird beispielsweise ein fester Wert vorgegeben und/oder ein gespeicherter Wert verwendet. Die entnehmbare Kapazität hängt unter anderem von mehreren Parametern, wie zum Beispiel von der Nennkapazität, dem Entladestrom, der Umgebungstemperatur der Batterie, der Entladeschlussspannung und/oder der Impulsstrombelastung ab. Da alle diese Parameter bei der Entwicklung des elektronischen Gerätes festgelegt sind bzw. ermittelt werden und somit vor Einsatz des elektronischen Gerätes bekannt sind, kann die Größe der entnehmbaren Kapazität im Allgemeinen als bekannter Wert oder als funktionaler Zusammenhang (zum Beispiel einer entnehmbaren Ladungsmenge pro Zeit und in Abhängigkeit der Temperatur) im elektronischen Gerät gespeichert werden. Beispielsweise kann die entnehmbare Kapazität einer Batterie alternativ aus einem entsprechenden Kennlinienfeld oder Kennlinienfeldern der Batterie, zum Beispiel Entlade-Kennlinien, ermittelt werden. Auch kann sie als eine Funktion des mittleren Entladestromes der Batterie pro Zeit und der Umgebungstemperatur der Batterie vorgegeben und bei der Ermittlung der Restlebensdauer der Batterie berücksichtigt werden.

Der mittlere Entladestrom der Batterie ist insbesondere ein aktivierte Betriebszustände des Gerätes repräsentierender Entladestrom, der über die aktivierte Dauer der aktivierten Betriebszustände der Batterie entnommen wird. Der mittlere Entladestrom kann beispielsweise wie folgt bestimmt werden:

- Bestimmen der Anzahl von Aktivierungen von Betriebszuständen des Gerätes,
- Bestimmen einer zugehörigen Betriebsdauer des jeweils aktivierten Betriebszustandes,
- Bestimmen eines den jeweils aktivierten Betriebszustand repräsentierenden Entladestroms,
- Bestimmen einer Häufigkeitsverteilung der aktivierten Betriebszustände anhand der ermittelten Anzahl von Aktivierungen,
- Bestimmen eines mittleren Entladestroms anhand der Häufigkeitsverteilung der aktivierten Betriebszustände, der ermittelten Betriebsdauern und der Entladeströme der aktivierten Betriebszustände.

Das Verfahren zur Bestimmung der Restlebensdauer der Batterie wird somit weiter vereinfacht, indem eine Vielzahl von erfassten und/oder gespeicherten Werten von zu berücksichtigenden Parametern, wie Betriebszustände und Entladeströme, beispielsweise zu der Häufigkeitsverteilung der aktivierten Betriebszustände beziehungsweise dem mittleren Entladestrom verdichtet werden. Hierdurch kann der Speicherbedarf im elektronischen Gerät reduziert werden. Darüber hinaus werden als Parameter bereits vorhandene, gemessene oder vorbestimmte, insbesondere vorbekannte, Werte, wie der Entladestrom und die Betriebszustände, verwendet, so dass zusätzliche Sensoren und zusätzliche aufwendige, energieverbrauchende Messverfahren bei der Bestimmung der Restlebensdauer der Batterie vermieden sind.

Unter "Bestimmen" mindestens eines oder mehrerer der vor- oder nachgenannten Parameter, wie Anzahl von Aktivierungen, Betriebsdauern, Entladestrom, Häufigkeitsverteilungen, mittlerer Entladestrom, wird insbesondere ein messtechnisches Erfassen von Parameterwerten, ein rechnerisches Erfassen von Parameterwerten und/oder ein Auslesen von gespeicherten Parameterwerten verstanden.

Alternativ oder zusätzlich wird unter dem Begriff "Bestimmen" auch die Verwendung von gespeicherten oder hinterlegten Werten der betreffenden Parameter, wie eines gespeicherten Wertes für den einen aktivierten Betriebszustand repräsentierenden Entladestrom und/oder ein gespeicherter Wert für die einen aktivierten Betriebszustand repräsentierende Betriebsdauer, verstanden.

Unter dem Begriff "Aktivierung von Betriebszuständen" wird insbesondere das Einschalten des elektronischen Gerätes in einen der Betriebszustände, wie zum Beispiel in einen Betriebsmodus, einen Messmodus, einen Installationsmodus und/oder einen Sendemodus und/oder das Umschalten von einem Ruhemodus in einen der Betriebszustände, wie in einen Betriebsmodus, Messmodus, Installationsmodus und/oder Sendemodus, des elektronischen Gerätes verstanden.

Unter dem Begriff "Betriebsdauer des jeweils aktivierten Betriebszustandes" wird insbesondere die zeitliche Dauer der Aktivierung des jeweiligen Betriebszustandes, zum Beispiel 3 ms Messdauer im Messmodus, 2 ms Sendedauer im Sendemodus, 5 Minuten Installationsdauer im Installationsmodus, oder dergleichen verstanden.

Unter dem Begriff "Entladestrom des jeweils aktivierten Betriebszustandes" wird insbesondere der Wert des der Batterie entnommenen Stroms verstanden. Die Menge der genutzten elektrischen Energie (= elektrische Ladung, umgangssprachlich auch Stromverbrauch oder Energiemenge genannt) während der zeitlichen Dauer der Aktivierung des aktivierten Betriebszustandes des elektronischen Gerätes erhält man durch die Multiplikation des Entladestroms mit der Dauer des aktivierten Betriebszustandes. Der jeweilige Entladestrom eines aktivierten Betriebszustandes des elektronischen Gerätes und/oder die entnommene elektrische Ladung (Entladestrom * Entladezeit) der Batterie kann zum Beispiel bei der Entwicklung des elektronischen Gerätes vorab ermittelt und im elektronischen Gerät gespeichert werden. Somit können als Entladestrom des jeweils aktivierten Betriebszustandes gespeicherte Werte verwendet werden. Hierfür muss nur das Auftreten des Betriebszustandes selbst identifiziert werden. Aufwendige aktuelle Strom- und/oder Spannungsmessungen können dadurch entfallen.

Unter dem Begriff "Häufigkeitsverteilung der aktivierten Betriebszustände" wird insbesondere eine Funktion verstanden, die darstellt, wie oft die unterschiedlichen Betriebszustände aktiviert wurden.

Unter dem Begriff "mittlerer Entladestrom" wird insbesondere ein über alle Betriebszustände und über die vorgegebene Zeitdauer ermittelter Mittelwert der Entladeströme verstanden.

Die Selbstentladung als Funktion der mittleren Batterietemperatur kann darüber hinaus für eine vorgegebene Zeitdauer, von zum Beispiel einem Jahr, mit Hilfe der sogenannten Arrhenius-Gleichung bestimmt werden:

$$S_a = A \cdot e^{-\left(\frac{E_A}{R \cdot T_m}\right)} \qquad\qquad [2]$$

mit $S_a$ = Selbstentladung pro vorgegebene Zeitdauer, a = vorgegebene Zeitdauer, A = präexponentieller Faktor, $E_A$ = Aktivierungsenergie, R = universelle Gaskonstante, $T_m$ = mittlere Batterietemperatur.

Der präexponentielle Faktor A und die Aktivierungsenergie $E_A$ eines bestimmten Batterietyps können beispielsweise anhand von Labormesswerten der Selbstentladung als Funktion der Temperatur bestimmt werden. Diese für einen Batterietyp charakteristische Funktion kann vom Hersteller der Batterie bereitgestellt oder selbst gemessen und bei der Ermittlung der Restlebensdauer der Batterie entsprechend berücksichtigt werden. Beispielsweise wird die Selbstentladung eines bestimmten Batterietyps in Laborversuchen bestimmt, wobei mehrere Batterien gleichen Batterietyps bei einer bestimmten Temperatur über einen vorgegebenen Zeitraum gelagert und danach deren Restkapazitäten bestimmt werden. Beispielsweise liegt die Selbstentladung (auch Selbstentladungsrate genannt) für Lithium-Metall-Batterien bei circa 0,5% oder 1% pro Jahr bei Raumtemperatur, insbesondere bei +25°C. Diese vorab oder in einem Labor ermittelten Werte für die Selbstentladung bei bestimmten Batterietemperaturen können dann in dem betreffenden elektronischen Gerät gespeichert und bei der Ermittlung der Restlebensdauer berücksichtigt werden. Alternativ werden der präexponentielle Faktor A und die Aktivierungsenergie $E_A$ eines bestimmten Batterietyps im Gerät gespeichert, so dass die Selbstentladungsrate im Gerät für jede mittlere Batterietemperatur berechnet werden kann.

Vorteilhafterweise wird die mittlere Batterietemperatur anhand einer Häufigkeitsverteilung der Batterietemperaturen, insbesondere zu vorgegebenen Betriebszuständen, oder einer Häufigkeitsverteilung von Batterietemperaturintervallen, insbesondere zu vorgegebenen Betriebszuständen, bestimmt.

Das Verfahren kann darüber hinaus folgende Schritte zur Bestimmung einer mittleren Batterietemperatur umfassen:

- Bestimmen von Batterietemperaturen oder Batterietemperaturintervallen,
- Bestimmen einer Häufigkeitsverteilung der Batterietemperaturen oder einer Häufigkeitsverteilung der Batterietemperaturintervalle und
- Bestimmen einer mittleren Batterietemperatur anhand der Häufigkeitsverteilung der Batterietemperaturen und/oder der Häufigkeitsverteilung der Batterietemperaturintervalle.

Die Batterietemperatur kann mit Hilfe eines Temperatursensors, der an oder in der Batterie angeordnet ist, erfasst werden. Dazu wird die Temperatur dieses zusätzlichen Sensors beispielsweise regelmäßig gemessen. Um diesen zusätzlichen Sensor zu vermeiden, kann, insbesondere bei kompakten Geräten, bei denen die Batterie und der Mikrocontroller des Messgerätes eng benachbart angeordnet sind und damit die gleiche Temperatur aufweisen, ein vorhandener integrierter Temperatursensor des Mikrocontrollers verwendet werden. Anhand der ermittelten Häufigkeitsverteilung der erfassten Batterietemperaturen wird dann die mittlere Batterietemperatur ermittelt. Bei Implementierung des Verfahrens in einem Verbrauchszähler oder Verbrauchsmessgerät, wie einem Heizkostenverteiler, wird beispielsweise als Batterietemperatur vorteilhaft die Mikrocontroller- oder Prozessortemperatur verwendet. Ein zusätzlicher Sensor ist somit nicht erforderlich.

Anschließend kann die Restlebensdauer der Batterie zumindest anhand des mittleren Entladestroms, der mittleren Batterietemperatur und der anfangs verfügbaren Batteriekapazität mit Kenntnis der Selbstentladung (= Selbstentladungsrate als Funktion der mittleren Batterietemperatur) der Batterie bestimmt werden.

Das Verfahren zur Bestimmung der Restlebensdauer der Batterie zeichnet sich insbesondere dadurch aus, dass nicht exakte zeitliche Verläufe des Entladestroms und der Batterietemperatur benötigt werden, denn auch aus den exakten zeitlichen Verläufen für Endladestrom und mittlerer Batterietemperatur werden letztlich ein mittlerer Entladestrom und eine mittlere Batterietemperatur als Zwischenwerte berechnet, um die Restlebensdauer zu kalkulieren. Eine Bestimmung des mittleren Endladestroms und der mittleren Batterietemperatur aus den entsprechenden Häufigkeitsverteilungen spart dagegen Speicherplatz und Rechenaufwand. Somit ist ein einfaches, ohne zusätzliche Messungen realisierbares, nicht rechenintensives und nicht speicherintensives und somit sehr energieeffizientes Verfahren zur Bestimmung der Restlebensdauer der Batterie gegeben.

Die Erfindung geht dabei von der Überlegung aus, dass bei batteriebetriebenen, elektronischen Geräten mit langer Lebensdauer, von zum Beispiel 10 Jahren und mehr, es insbesondere darauf an kommt, alle nicht unbedingt notwendigen Aktivitäten zu vermeiden. Jede Messung, Berechnung, Speicherung und Datenmanipulation kostet Energie, die die Lebensdauer der Batterie und somit des elektronischen Gerätes verringert. Aus diesem Grund wird ein Verfahren für die Ermittlung einer Restlebensdauer Prognose vorgeschlagen, dass ohne Strom- und Spannungsmessungen auskommt.

Mit anderen Worten: Es sind keine Strom- und Spannungsmessungen notwendig, denn die Energieverbräuche (Entladeströme * Zeit, auch Stromverbräuche genannt) aller Betriebszustände können bei der Entwicklung des Gerätes ermittelt und im Gerät gespeichert werden. Somit muss nur das Auftreten des Betriebszustandes selbst festgestellt werden. Insbesondere bei Lithium-Metall-Batterien kann auf Spannungsmessungen verzichtet werden, da die Batteriespannung über große Teile der Batterielebensdauer nahezu unverändert vorliegt. Bei erfindungsgemäßen Verfahren wird somit auf eine Messung der Batteriespannung verzichtet, da die Prognose auf dem Energieverbrauch durch das Gerät, insbesondere dem entnommenen mittleren Entladestrom, und der Selbstentladung der Batterie, als Funktion der Temperatur, beruht.

Die Restlebensdauer einer Batterie wird durch die Größe der entnehmbaren Kapazität, des mittleren Stroms, insbesondere des mittleren Stromverbrauchs (= Entladestrom * Zeit), und durch die Selbstentladung der Batterie, als Funktion der mittleren Batterietemperatur, bestimmt.

Bei einem batteriebetriebenen elektronischen Gerät mit langer Lebensdauer, wie zum Beispiel in einem Haushalt montierten Verbrauchsmessgeräten oder Verbrauchszählern, wie Kalt- und Warmwasserzähler, Heizkostenverteiler, Wärmemengenmesser usw. befindet sich das elektronische Gerät den überwiegenden Teil der Betriebszeit in einem Betriebsmode mit sehr geringem Energiebedarf. Der Stromverbrauch liegt hierbei im Allgemeinen in der Größenordnung der Selbstentladung der Batterie. Auch dieser Parameter wird bei der Geräteentwicklung ermittelt und kann somit im Gerät fest als Basisstrom gespeichert werden. Der Basisstrom kennzeichnet den Stromverbrauch des elektronischen Gerätes in jenen Betriebsmodi, die einen vorgegebenen, sehr geringen Energiebedarf aufweisen, der in etwa der Selbstentladung der Batterie entspricht.

Das elektronische Gerät umfasst beispielsweise ein Rechenwerk, insbesondere einen Mikrocontroller bzw. Mikroprozessor, zur Steuerung der implementierten Verfahren und Funktionen des elektronischen Geräts. In dem Rechenwerk werden beispielsweise alle Aktivitäten durch einen Zustandsautomaten gesteuert. Das Rechenwerk erfasst beispielsweise alle aktivierten Betriebszustände des elektronischen Gerätes. Die Häufigkeiten und/oder Betriebsdauern aller, insbesondere relevanten, Betriebszustände können durch einfache Zählungen mittels des Rechenwerks erfasst werden. Mit der Kenntnis der Betriebsdauern der relevanten Betriebszustände und ihrer charakteristischen Entladeströme (Stromverbräuche) und des gespeicherten Basisstroms, insbesondere für Betriebsmodi mit sehr geringem Energiebedarf, kann der mittlere Stromverbrauch (auch mittlere Stromentnahme oder Entladestrom genannt) des elektronischen Gerätes ermittelt werden. Relevante Betriebszustände im Sinne dieser Betrachtung sind insbesondere alle Betriebszustände, in denen der Entladestrom des elektronischen Gerätes vom Basisstrom abweicht, insbesondere in denen der Entladestrom größer ist als der Basisstrom.

Sollten die Häufigkeiten der relevanten Betriebszustände schon durch die Parametrierung des elektronischen Gerätes festgelegt und während der Lebenszeit des elektronischen Gerätes unveränderlich sein, so kann auch der mittlere Strom schon im Vorfeld ermittelt und im Gerät als fester Parameter abgespeichert werden. Hierdurch werden weitere Rechenkapazitäten eingespart und die Batterie des elektronischen Gerätes geschont.

Das Bestimmen eines oder mehrerer Betriebszustände kann beispielsweise ein Bestimmen eines Kommunikationsmodus des elektronischen Gerätes, eines Sendemodus des elektronischen Gerätes, eines Ruhemodus des elektronischen Gerätes, eines Messmodus des elektronischen Gerätes, eines Rechen- oder Speichermodus des elektronischen Gerätes, eines Temperaturmessmodus der die Batterie kennzeichnenden Batterietemperatur und/oder eines Einsatzmodus eines vorgesehenen Standortes des elektronischen Gerätes, zum Beispiel Dauer- oder zeitweise Einsatz an einem warmen Standort des elektronischen Gerätes, zum Beispiel in einem Heizungsraum oder einem Dachboden, oder einem kühlen Standort, zum Beispiel in einem Keller, umfassen. Hierzu weist das elektronische Gerät beispielsweise ein Rechenwerk auf, das die entsprechenden Betriebszustände steuert und bei deren Aktivierung elektronisch erfasst.

Der mittlere Entladestrom (auch mittlere Stromaufnahme oder mittlerer Stromverbrauch genannt) kann beispielsweise in Abhängigkeit der Häufigkeitsverteilung der relevanten Betriebszustände wie folgt berechnet werden:

$$I_m = (I_B * t + H_{B1} * D_{B1} * I_{B1} + H_{B2} * D_{B2} * I_{B2} + \ldots + H_{Bn} * D_{Bn} * I_{Bn}) / t \qquad [3]$$

$I_m$     mittlerer Entladestrom
$I_B$     Basisstrom
$I_{Bn}$     Entladestrom des Betriebszustandes n
$H_{Bn}$     Häufigkeit $H_{Bn}$ des Betriebszustands $B_n$
$D_{Bn}$     Betriebsdauer D des Betriebszustandes $B_n$
$t$     Zeit

Formel 3 kann dann angewendet werden, wenn die Summe der Betriebsdauern $\sum D_{Bn}$ sehr klein gegen t ist. Sonst gilt:

$$I_m = (I_B * (t - \sum D_{Bi}) + H_{B1} * D_{B1} * I_{B1} + H_{B2} * D_{B2} * I_{B2} + \ldots + H_{Bn} * D_{Bn} * I_{Bn}) / t \quad [4]$$

Die Batterietemperatur kann mit einem beliebigen Temperatursensor an, in oder in der Nähe der Batterie gemessen werden. Vorteilhaft ist es, einen schon vorhandenen Temperatursensor hierfür zu verwenden.
Je nachdem in welchem Einsatztemperaturbereich und mit welcher Temperaturänderungsdynamik zu rechnen ist, kann die Häufigkeit der Temperaturmessungen gewählt und entsprechend eingestellt werden. Auch hierbei kommt es darauf an, möglichst selten zu messen.
Für die Berechnung der mittleren Batterietemperatur ist es nicht notwendig den zeitlichen Verlauf der Batterietemperatur abzuspeichern. Sinnvoll ist es auch hier, die Häufigkeiten des Vorliegens einer bestimmten Batterietemperatur zu erfassen.
Die mittlere Batterietemperatur $T_m$ kann wie folgt bestimmt werden:

$$T_m = (H_{T1} * T_{B1} + H_{T2} * T_{B2} + \ldots + H_{Tn} * T_{Bn}) / (\sum H_{Ti}) \qquad [5]$$

$T_m$     mittlere Batterietemperatur
$H_{Tn}$     Häufigkeit Batterietemperatur n
$T_{Bn}$     Batterietemperatur n

Im einfachsten Fall ist die Häufigkeit $H_{Tn}$ der Batterietemperatur $T_{Bn}$ eine ganze Zahl und die Summe der Häufigkeiten $H_{Tn}$ die Anzahl der insgesamt durchgeführten Temperaturmessungen. Wird zum Beispiel einmal pro Stunde die Batterietemperatur $T_{Bn}$ gemessen und zweimal im Jahr die Batterietemperatur $T_{Bn}$ von 70°C ermittelt, so ist die Häufigkeit $H_{T70}$ der Batterietemperatur $T_{Bn}$ von 70°C gleich 2/(24*365), bezogen auf ein Jahr.
Anhand der Gleichung 5 kann die Häufigkeitsverteilung der Batterietemperaturen ermittelt werden. Um die Häufigkeitsverteilung der Batterietemperaturen möglichst kompakt im elektronischen Gerät zu speichern, kann der Arbeitstemperaturbereich in Intervalle aufgeteilt werden und die Häufigkeitsverteilung der Batterietemperatur mit diskreten Batterietemperaturintervallen abgespeichert werden.
Beispielsweise kann die mittlere Batterietemperatur bei der Häufigkeitsverteilung der Batterietemperatur in Temperaturintervallen wie folgt bestimmt werden:

$$T_m = (H_{TI1} * T_{I1} + H_{TI2} * T_{I2} + \ldots + H_{TIn} * T_{In}) / (\sum H_{TIi}) \qquad [6]$$

$T_m$     mittlere Batterietemperatur

$H_{TIn}$     Häufigkeit Batterietemperaturintervall n

T$_{In}$    Batterietemperaturintervall n

Zum Beispiel kann dazu der Arbeitstemperaturbereich des Gerätes von zum Beispiel -40 °C bis 60°C in 5 K Intervalle aufgeteilt werden.

Für die Ermittlung der mittleren Batterietemperatur kann es weiterhin sinnvoll sein, die Häufigkeitsverteilung der Batterietemperatur mit einer Wichtungsfunktion zu verknüpfen. Zum Beispiel können höherer Batterietemperaturen mit einer höheren Wichtung versehen und entsprechend berücksichtigt werden.

Insbesondere bei kompakten elektronischen Geräten mit hoher thermischer Trägheit und enger räumlicher Anordnung von Batterie und Rechenwerk kann alternativ zur Batterietemperatur auch die Temperatur des Rechenwerkes und/oder die Temperatur eines anderen schon im Gehäuse vorhandenen Temperatursensors ermittelt werden. Befindet sich das Rechenwerk des elektronischen Gerätes zum Beispiel in einem Mikroprozessor bzw. Mikrocontroller und besitzt dieser einen integrierten Temperatursensor, so kann dieser sehr gut zur Messung der Temperatur des Rechenwerks benutzt werden.

Die Selbstentladung einer Batterie ist eine Funktion der mittleren Batterietemperatur. Bevorzugt wird die Selbstentladung pro vorgegebener Zeitdauer als Funktion der Batterietemperatur auf Basis einer Häufigkeitsverteilung der Batterietemperaturen und/oder einer Häufigkeitsverteilung von Batterietemperaturintervallen ermittelt wird.

Diese Selbstentladung hat einen umso größeren Einfluss auf die Batterielebensdauer je höher sie ist. Beispielsweise geht man davon aus, dass sich die Selbstentladung alle 10 K verdoppelt.

Das Bestimmen der Restkapazität für einen Zeitpunkt kann erfolgen gemäß Gleichung:

$$C_R = C_{eb} \cdot (1 - S_a)^{\frac{t}{a}} - I_m \cdot t \qquad [7]$$

mit $C_R$= Restkapazität, $C_{eb}$ = entnehmbare Kapazität, $S_a$ = Selbstentladung pro Jahr, a = Dauer eines Jahres, $I_m$ = mittlerer Entladestrom, t = Zeit.

Die entnehmbare Kapazität einer Batterie kann aus den Kennlinienfeldern der Batterie ermittelt werden. Im Allgemeinen ist sie eine Funktion des mittleren Entladestroms und der Umgebungstemperatur. Alternativ kann die entnehmbare Kapazität als eine Funktion der Batterietemperatur, einer Entladeschlussspannung und einer Impulsstrombelastung bestimmt und vorgegeben werden.

Ist die Restkapazität gleich null, so ist das Ende der Lebensdauer des Gerätes erreicht. Somit kann durch Umstellen der Gleichung [7] die Restlebensdauer $t_R$ der Batterie gemäß Gleichung [1] bestimmt werden.

Diese transzendente Gleichung [1] lässt sich durch sukzessive Approximation lösen. Sie konvergiert bei der Wahl eines geeigneten Startwertes für die Restlebensdauer $t_R$ sehr schnell, so dass sie auch in einem Rechenwerk mit geringer Leistungsfähigkeit einfach gelöst werden kann.

Das erfindungsgemäße Computerprogrammprodukt umfasst Programmcodeteile zur Durchführung des zuvor beschriebenen Verfahrens, wobei das Computerprogrammprodukt von einem Prozessor des elektronischen Gerätes ausgeführt wird.

Das erfindungsgemäße elektronische Gerät umfasst ein Prognosesystem zur Bestimmung der Restlebensdauer einer Batterie eines elektronischen Gerätes, insbesondere eines Verbrauchszählers, wobei das Prognosesystem das Computerprogrammprodukt umfasst, das von einem Rechenwerk oder Prozessor des elektronischen Gerätes ausgeführt wird.

In einer möglichen Ausführungsform sind ein oder mehrere Zähler, insbesondere Zustands- oder Eventzähler, und/oder ein Zustandsautomat für die Ermittlung der Anzahl von Aktivierungen von verschiedenen, diskreten, relevanten Betriebs- oder Lastzuständen der Batterie des elektronischen Gerätes vorgesehen.

Zusätzlich kann das elektronische Gerät mindestens eine Zeiterfassungseinheit, insbesondere eine Vorrichtung für die Ermittlung von Betriebs- oder Lastdauern der verschiedenen, diskreten, relevanten Betriebs- oder Lastzustände, eine Temperaturmesseinrichtung zur Ermittlung einer Batterietemperatur, mit einem Batterietemperatursensor, der Prozessortemperatur und/oder einer Sensortemperatur im Inneren des Gerätes, und/oder ein Rechenwerk umfassen. Das Rechenwerk kann anhand der erfassten und/oder bestimmten Werte für Betriebszustände und/oder Batterietemperatur und/oder der ermittelten und/oder bekannten Anzahl der Betriebszustände und der ermittelten und/oder den bekannten Betriebsdauern der verschiedenen, diskreten, relevanten Betriebszustände eine erste Häufigkeitsverteilung für die diskreten, relevanten Betriebs- oder Lastzustände ermitteln. Darüber hinaus kann das Rechenwerk aus den gemessenen Batterietemperaturen eine zweite Häufigkeitsverteilung der Batterietemperatur mit diskreten Temperaturintervallen ermitteln. Ferner kann das Rechenwerk aus der ersten Häufigkeitsverteilung für die verschiedenen, diskreten, relevanten Betriebszuständen und der zweiten Häufigkeitsverteilung der diskreten Batterietemperaturintervalle auf der Basis der Batterienennkapazität und der Batteriekennlinien eine Restlebensdauerprognose ausführen und eine Restlebensdauer der Batterie ermitteln.

Mit anderen Worten werden beim Verfahren zur Ermittlung der Restlebensdauer des batteriebetriebenen, elektronischen Geräts, insbesondere mit einer Primärbatterie, mit wechselndem Stromverbrauch und sich ändernder Umgebungstemperatur, mit einem Rechenwerk und einer Speichereinrichtung sowie mit einem Batterietemperatursensor in einfacher Art und Weise im Rechenwerk mit Zustandszählungen von relevanten Betriebszuständen des elektronischen Gerätes eine erste Häufigkeitsverteilung der relevanten Betriebszustände erstellt und abgespeichert und mit den gemessenen Batterietemperaturen eine zweite Häufigkeitsverteilung der Batterietemperatur gebildet und im Speicher ablegt, aus den ersten Häufigkeitsverteilungen der relevanten Betriebszustände wird mit Kenntnis der Stromverbräuche, insbesondere Entladeströme, der relevanten Betriebszustände ein mittlerer Stromverbrauch oder ein mittlerer Entladestrom bestimmt, aus der zweiten Häufigkeitsverteilung der Batterietemperaturen eine mittlere Batterietemperatur bestimmt und aus dem mittleren Stromverbrauch oder dem mittleren Entladestrom und der mittleren Batterietemperatur dann eine Restlebensdauer der Batterie prognostiziert.

Diese transzendente Gleichung lässt sich durch sukzessive Approximation lösen. Sie konvergiert bei der Wahl eines geeigneten Startwertes für die Restlebensdauer $t_R$ sehr schnell, so dass sie auch in einem Rechenwerk mit geringer Leistungsfähigkeit einfach gelöst werden kann.

Ausführungsbeispiele der Erfindung werden im Folgenden anhand von Zeichnungen näher erläutert. Darin zeigen:

Fig. 1    in schematisch Darstellung ein batteriebetriebenes, elektronisches Gerät,

Fig. 2    ein Diagramm mit einer Häufigkeitsverteilung verschiedener Betriebszustände des elektronischen Gerätes,

Fig. 3    ein Diagramm mit einer Häufigkeitsverteilung verschiedener Batterietemperaturen,

Fig. 4    ein Diagramm mit einer Häufigkeitsverteilung verschiedener Batterietemperaturintervalle, und

Fig. 5    ein Diagramm einer Wichtungsfunktion für die Batterietemperatur.

Einander entsprechende Teile sind in allen Figuren mit den gleichen Bezugszeichen versehen.

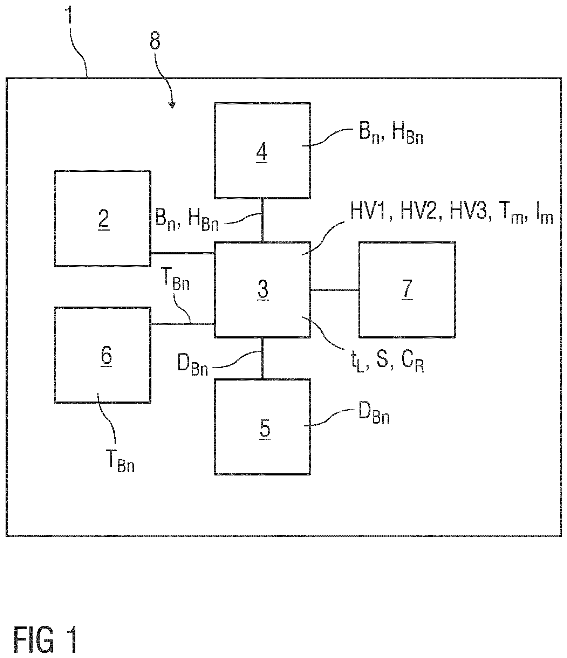

**Figur 1** zeigt einen schematischen Aufbau eines elektronischen Gerätes 1 mit einer Batterie 2 zur Versorgung des elektronischen Gerätes 1. Das elektronische Gerät 1 ist beispielsweise ein Messgerät, insbesondere ein Verbrauchsmessgerät, oder ein Verbrauchszähler, wie ein Heizkostenverteiler.

Die für den üblichen Gebrauch, wie zum Beispiel eine Verbrauchswerterfassung, erforderlichen Komponenten des elektronischen Gerätes 1 sind zur besseren Übersichtlichkeit in Figur 1 nicht näher dargestellt.

Figur 1 zeigt die für das erfindungsgemäße Verfahren zur Bestimmung einer Restlebensdauer $t_R$ der Batterie 2 (auch Restlebensdauerprognose genannt) erforderlichen Komponenten und/oder Baugruppen.

Die Batterie 2, zum Beispiel eine Lithium-Metall-Batterie, versorgt das elektronische Gerät 1 mit elektrischer Energie. Das elektronische Gerät 1 umfasst ein Rechenwerk 3, das alle Funktionen und/oder Aktivitäten des elektronischen Gerätes 1 gesteuert.

Darüber hinaus kann das elektronische Gerät 1 einen Zustandszähler 4 (auch Zustandsautomat oder Eventzähler genannt), eine Uhr 5, einen Batterietemperatursensor 6 und einen Speicher 7 umfassen.

Alle für den Energieverbrauch des elektronischen Gerätes 1 relevanten Betriebszustände $B_n$ werden durch den Zustandszähler 4 gezählt und deren Häufigkeiten $H_{Bn}$ bestimmt. Der Zustandszähler 4 führt die ermittelten Häufigkeiten $H_{Bn}$ dem Rechenwerk 3 zu, welches eine erste Häufigkeitsverteilung HV1 der Betriebszustände $B_n$ ermittelt. Anhand der Gleichung [3] oder [4] bestimmt das Rechenwerk 3 mit den Stromwerten der Entladeströme $I_{Bn}$ der einzelnen Betriebszuständen $B_n$ und den zugehörigen Betriebsdauern $D_{Bn}$ den mittleren Entladestrom $I_m$. Die zugehörigen Betriebsdauern $D_{Bn}$ sind entweder bekannt oder werden durch die Uhr 5 bestimmt.

Ein jeweils relevanter Betriebszustand $B_n$ ist insbesondere durch einen zugehörigen Entladestrom $I_{Bn}$ und eine zugehörige Betriebsdauer $D_{Bn}$ gekennzeichnet.

Die Häufigkeiten $H_{Bn}$ der relevanten Betriebszustände $B_n$, ihre zugehörigen Betriebsdauern $D_{Bn}$ und ihre zugehörigen Entladeströme $I_{Bn}$ können darüber hinaus im Speicher 7 des elektronischen Gerätes 1 hinterlegt werden. Dabei können diese Werte als feste Werte hinterlegt sein, wenn beispielsweise die Betriebszustände $B_n$ und deren Betriebsdauern $D_{Bn}$ und Entladeströme $I_{Bn}$ vorgegeben und/oder zum Beispiel herstellerseitig bekannt sind. Alternativ können die Entladeströme $I_{Bn}$ mittels eines nicht dargestellten Stromsensors der Verbrauchswerterfassung des elektronischen Gerätes 1 erfasst und für das erfindungsgemäße Verfahren verwendet werden. Da jede Messung selbst Energie verbraucht, verzichtet das vorliegende Verfahren jedoch hierauf.

Der Batterietemperatursensor 6 dient der Ermittlung der Batterietemperatur $T_{Bn}$. Die Batterietemperatur $T_{Bn}$ wird dem Rechenwerk 3 zugeführt, welches eine zweite Häufigkeitsverteilung HV2 der Batterietemperaturen $T_{Bn}$ und anhand der zweiten Häufigkeitsverteilung HV2 eine mittlere Batterietemperatur $T_m$ ermittelt gemäß der Gleichung [5].

Die zweite Häufigkeitsverteilung HV2 der Batterietemperaturen $T_{Bn}$ kann ebenfalls im Speicher 7 des elektronischen Gerätes 1 gespeichert werden.

Alternativ oder zusätzlich kann das Rechenwerk 3 eine dritte Häufigkeitsverteilung HV3 der Batterietemperatur $T_{Bn}$ in Batterietemperaturintervallen $T_{In}$ und eine mittlere Batterietemperatur $T_m$ ermitteln gemäß der Gleichung [6].

Insbesondere bei kompakten elektronischen Geräten 1 mit hoher thermischer Trägheit und enger räumlicher Anordnung von Batterie 2 und Rechenwerk 3 kann alternativ zur Batterietemperatur $T_{Bn}$ auch die Temperatur des Rechenwerkes 3 und/oder die Temperatur im Inneren des Gerätes 1 ermittelt werden. Befindet sich das Rechenwerk 3 des elektronischen Gerätes 1 zum Beispiel in einem Mikrocontroller oder Prozessor und besitzt dieser einen integrierten Temperatursensor, so kann dieser sehr gut zur Messung der Temperatur des Rechenwerks 3 benutzt werden und die erfassten Temperaturwerte als Batterietemperatur $T_{Bn}$ für das erfindungsgemäße Verfahren verwendet werden. Ein zusätzlicher Temperatursensor entfällt somit.

Die mittlere Batterietemperatur $T_m$ wird benötigt, um die Selbstentladung Sa pro vorgegebener Zeitdauer a, zum Beispiel von einem Jahr, der Batterie 2 gemäß Gleichung [2] zu bestimmen und die Restlebensdauer $t_R$ gemäß Gleichung [1] zu prognostizieren. Diese mittlere Batterietemperatur $T_m$ hat einen umso größeren Einfluss auf die Batterielebensdauer und somit die zu ermittelnde Restlebensdauer $t_R$ je höher sie ist. Beispielsweise geht man davon aus, dass sich die Selbstentladung S alle 10 K verdoppelt.

Die Selbstentladung S eines bestimmten Batterietyps kann beispielsweise entweder durch den Batteriehersteller oder durch den Verwender der Batterie 2 in Laborversuchen ermittelt werden. Mit der ermittelten Funktion der Selbstentladung S, zum Beispiel als Funktion der Temperatur, können die Koeffizienten der Arrhenius-Gleichung gemäß Gleichung 2 bestimmt werden.

Ist die Restkapazität $C_R$ gleich null, so ist das Ende der Lebensdauer des elektronischen Gerätes 1 erreicht. Somit kann durch Umstellen der Gleichung [7] die Restlebensdauer $t_R$ der Batterie 2 prognostiziert werden gemäß der transzendenten Gleichung [1]. Diese transzendente Gleichung [1] wird durch sukzessive Approximation gelöst. Sie konvergiert bei der Wahl eines geeigneten Startwertes für die Restlebensdauer $t_R$ sehr schnell, so dass sie auch in einem Rechenwerk 3 mit geringer Leistungsfähigkeit einfach gelöst werden kann.

Im Rechenwerk 3 ist ein Computerprogrammprodukt implementiert, das Programmcodeteile zur Durchführung des zuvor beschriebenen Verfahrens umfasst, wobei das Computerprogrammprodukt vom Rechenwerk 3 des elektronischen Gerätes 1 ausgeführt wird.

Die zur Ausführung des zuvor beschriebenen Verfahrens erforderlichen Komponenten, wie das Rechenwerk 3 (mit integriertem Temperatursensor), Zustandszähler 4, Speicher 7 und optional Uhr 5 oder anderer Zeitmesser sowie Batterietemperatursensor 6, stellen ein Prognosesystem 8 zur Bestimmung der Restlebensdauer $t_R$ der Batterie 2 des elektronischen Gerätes 1 dar, wobei das Prognosesystem 8 das Computerprogrammprodukt umfasst, das von dem Rechenwerk 3, insbesondere einem Prozessor, des elektronischen Gerätes 1 ausgeführt wird.

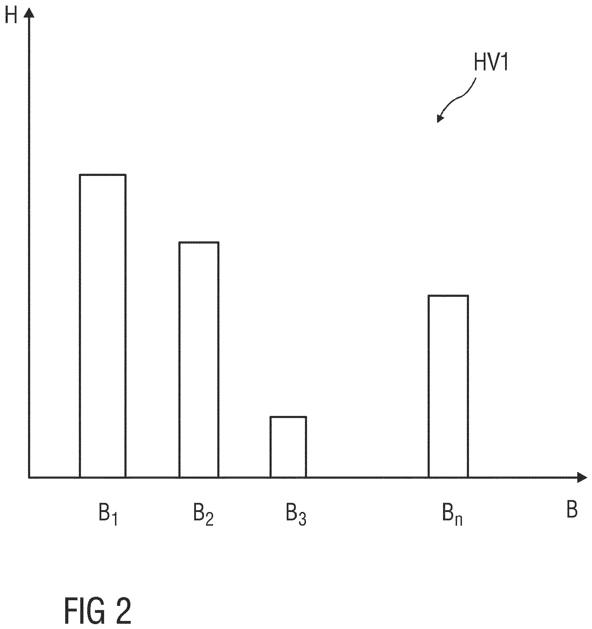

**Figur 2** zeigt ein Diagramm der Häufigkeit H von Betriebszuständen $B_1$ bis $B_n$ mit einem Beispiel für eine erste Häufigkeitsverteilung HV1 der relevanten Betriebszustände $B_1$ bis $B_n$.

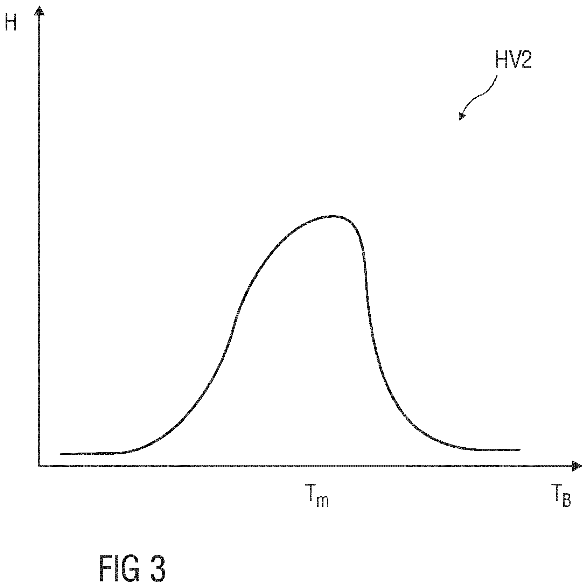

**Figur 3** zeigt ein Diagramm der Häufigkeit H von Batterietemperaturen $T_{Bn}$ mit einem Beispiel für eine zweite Häufigkeitsverteilung HV2 der Batterietemperaturen $T_{Bn}$ mit der mittleren Batterietemperatur $T_m$.

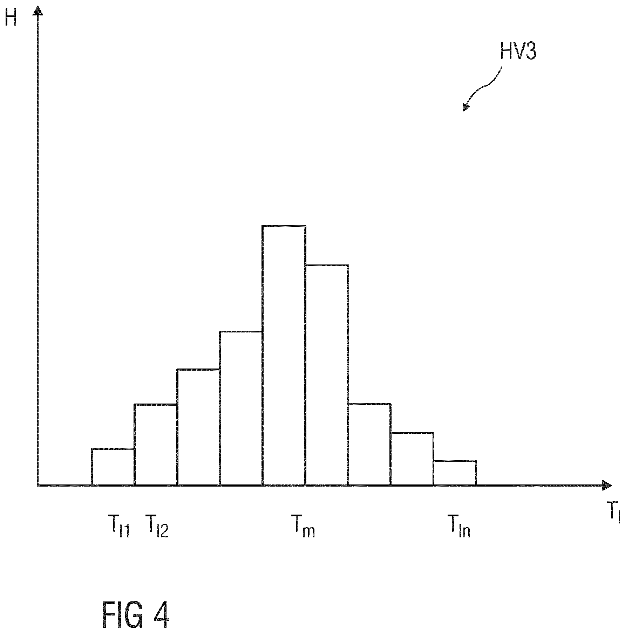

**Figur 4** zeigt ein Diagramm der Häufigkeit H von Batterietemperaturintervallen $T_{In}$ mit einem Beispiel für eine dritte Häufigkeitsverteilung HV3 von Batterietemperaturintervallen $T_{In}$ mit der mittleren Batterietemperatur $T_m$.

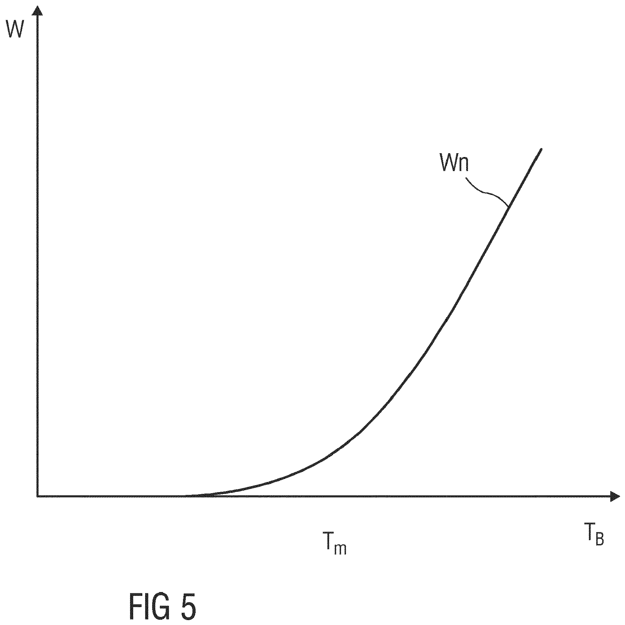

**Figur 5** zeigt beispielhaft eine Wichtungsfunktion Wn für die Batterietemperatur $T_{Bn}$.

**BEZUGSZEICHENLISTE**

1   elektronisches Gerät
2   Batterie
3   Rechenwerk
4   Zustandszähler
5   Uhr
6   Batterietemperatursensor
7   Speicher
8   Prognosesystem

$B_n$   Betriebszustände
$C_{eb}$   entnehmbare Batteriekapazität
$C_R$   Restkapazität der Batterie
$D_{Bn}$   Betriebsdauer

H        Häufigkeit
HV1     Häufigkeitsverteilung von Betriebszuständen $B_n$
HV2     Häufigkeitsverteilung von Batterietemperaturen $T_{Bn}$
HV3     Häufigkeitsverteilung von Batterietemperaturintervallen $T_{In}$
S        Selbstentladung
$S_a$      Selbstentladung pro Jahr
$I_{Bn}$     Entladestrom
$I_m$      mittlerer Entladestrom
t        Zeit
$t_R$      Restlebensdauer
$T_{Bn}$     Batterietemperatur
$T_m$      Batterietemperaturintervall
$T_m$      mittlere Batterietemperatur
$W_n$      Wichtungsfunktion


**Patentansprüche**

1. Verfahren zum Bestimmen der Restlebensdauer ($t_R$) einer Batterie (2) eines elektronischen Gerätes (1), insbesondere eines Messgerätes (1) mit wechselndem Stromverbrauch, wobei

   die Restlebensdauer ($t_R$) anhand einer entnehmbaren Kapazität ($c_{eb}$) der Batterie (2), einer vorgegebenen Zeitdauer (a), einer Selbstentladung ($S_a$) der Batterie (2) pro vorgegebener Zeitdauer (a) und eines mittleren Entladestroms ($I_m$) der Batterie (2) wie folgt bestimmt wird:

$$t_R = \frac{C_{eb}}{I_m} \cdot (1 - S_a)^{\frac{t_R}{a}}$$

   mit $C_{eb}$ = entnehmbare Kapazität, $S_a$ = Selbstentladung pro vorgegebener Zeitdauer, zum Beispiel ein Jahr, a = vorgegebene Zeitdauer (zum Beispiel ein Jahr oder ein Monat), $I_m$ = mittlerer Entladestrom , $t_R$ = Restlebensdauer, wobei der mittlere Entladestrom ($I_m$) der Batterie (2) anhand einer Häufigkeitsverteilung (HV1) einer Anzahl von Betriebszuständen ($B_n$) bestimmt wird.

2. Verfahren nach Anspruch 1, wobei die entnehmbare Kapazität $C_{eb}$ als fester Wert vorgegeben wird und/oder ein gespeicherter Wert verwendet wird.

3. Verfahren nach Anspruch 1, wobei die entnehmbare Kapazität $C_{eb}$ auf der Basis eines Kennlinienfeldes als Funktion des mittleren Entladestromes ($I_m$), der mittleren Temperatur $T_m$ und der Entladeschlussspannung in einem Rechenwerk (3) des elektronischen Gerätes (1) bestimmt wird.

4. Verfahren nach einem der vorhergehenden Ansprüche, wobei eine Anzahl von Betriebszuständen (Bn) vorgegeben wird.

5. Verfahren nach Anspruch 4, wobei eine Anzahl von Aktivierungen der vorgegebenen Betriebszuständen ($B_n$) erfasst wird.

6. Verfahren nach Anspruch 4 oder 5, wobei der mittlere Entladestrom ($I_m$) wie folgt bestimmt wird:

   - Bestimmen der Anzahl von Aktivierungen von vorgegebenen Betriebszuständen ($B_n$) des elektronischen Gerätes (1),
   - Bestimmen einer zugehörigen Betriebsdauer ($D_{Bn}$) des jeweils aktivierten Betriebszustandes ($B_n$),
   - Bestimmen eines den jeweils aktivierten Betriebszustand ($B_n$) repräsentierenden Entladestroms ($I_{Bn}$) ,
   - Bestimmen einer Häufigkeitsverteilung (HV1) der aktivierten Betriebszuständen ($B_n$) anhand der ermittelten Anzahl von Aktivierungen,
   - Bestimmen eines mittleren Entladestroms ($I_m$) anhand der Häufigkeitsverteilung (HV1) der aktivierten Betriebszustände($B_n$) und der ermittelten Betriebsdauern ($D_{Bn}$) und der Entladeströme ($I_{Bn}$) der aktivierten Be-

triebszustände (B_n).

7. Verfahren nach einem der vorhergehenden Ansprüchen, wobei die Selbstentladung ($S_a$) pro vorgegebener Zeitdauer als Funktion der Batterietemperatur ($T_{Bn}$) auf Basis einer Häufigkeitsverteilung (HV2) der Batterietemperaturen ($T_{Bn}$) und/oder einer Häufigkeitsverteilung (HV3) von Batterietemperaturintervallen ($T_{In}$) ermittelt wird.

8. Verfahren nach einem der vorhergehenden Ansprüche, wobei die Selbstentladung (Sa) pro vorgegebener Zeitdauer als Funktion der mittleren Batterietemperatur gemäß Arrhenius-Gleichung bestimmt wird:

$$S_a = A \cdot e^{-\left(\frac{E_A}{R \cdot T_m}\right)}$$

mit $S_a$ = Selbstentladung pro vorgegebene Zeitdauer, a = vorgegebene Zeitdauer, A = präexponentieller Faktor, $E_A$ = Aktivierungsenergie, R = universelle Gaskonstante, $T_m$ = mittlere Batterietemperatur.

9. Verfahren nach Anspruch 7 oder 8, wobei die mittlere Batterietemperatur anhand einer Häufigkeitsverteilung (HV2) von Batterietemperaturen ($T_{Bn}$) und/oder einer Häufigkeitsverteilung (HV3) von Batterietemperaturintervallen ($T_{In}$) bestimmt wird.

10. Verfahren nach einem der Ansprüche 7 bis 9, wobei die mittlere Batterietemperatur ($T_m$) wie folgt bestimmt wird:

   - Bestimmen von Batterietemperaturen ($T_{Bn}$) oder Batterietemperaturintervallen ($T_{In}$),
   - Bestimmen einer Häufigkeitsverteilung (HV2) der Batterietemperaturen ($T_{Bn}$) und/oder einer Häufigkeitsverteilung (HV3) von Batterietemperaturintervallen ($T_{In}$),
   - Bestimmen einer mittleren Batterietemperatur ($T_m$) anhand der Häufigkeitsverteilung (HV2) der Batterietemperaturen ($T_{Bn}$) und/oder der Häufigkeitsverteilung (HV3) der Batterietemperaturintervallen ($T_{In}$).

11. Verfahren nach einem der vorhergehenden Ansprüche, wobei das Bestimmen eines oder mehrerer Betriebszustände ($B_n$) ein Bestimmen eines Messmodus, eines Rechenmodus, eines Speichermodus, eines Kommunikationsmodus, eines Sendemodus, eines Ruhemodus, eines Temperaturmodus und/oder eines Installationsmodus des elektronischen Gerätes (1), und/oder eines Einsatzmodus des elektronischen Gerätes (1) an einem Standort umfasst.

12. Computerprogrammprodukt umfassend Programmcodeteile zur Durchführung eines Verfahrens nach einem der Ansprüche 1 bis 11, wenn das Computerprogrammprodukt von einem Rechenwerk (3) des elektronischen Gerätes (1) ausgeführt wird.

13. Elektronisches Gerät (1) mit einem Prognosesystem (8) zur Bestimmung der Restlebensdauer ($t_R$) einer Batterie (2) des elektronischen Gerätes (1), insbesondere eines Verbrauchszählers, wobei das Prognosesystem (8) ein Computerprogrammprodukt nach Anspruch 12 umfasst, das von dem Rechenwerk (3) ausgeführt wird.

**Claims**

1. Method for determining the remaining life ($t_R$) of a battery (2) of an electronic device (1), in particular of a measuring device (1) having a varying power consumption, wherein

   the remaining life ($t_R$) is determined on the basis of a retrievable capacity ($c_{eb}$) of the battery (2), a predefined period of time (a), a self-discharge ($S_a$) of the battery (2) per predefined period of time (a) and a mean discharge current ($I_m$) of the battery (2) as follows:

$$t_R = \frac{c_{eb}}{I_m} \cdot (1 - S_a)^{\frac{t_R}{a}}$$

where $C_{eb}$ = retrievable capacity, $S_a$ = self-discharge per predefined period of time, for example one year, a = predefined period of time (for example one year or one month), $I_m$ = mean discharge current, $t_R$ = remaining life, wherein the mean discharge current ($I_m$) of the battery (2) is determined on the basis of a frequency distribution (HV1) of a number of operating states ($B_n$).

2. Method according to Claim 1, wherein the retrievable capacity $C_{eb}$ is predefined as a fixed value and/or a stored value is used.

3. Method according to Claim 1, wherein the retrievable capacity $C_{eb}$ is determined based on a family of characteristics as a function of the mean discharge current ($I_m$), the mean temperature $T_m$ and the discharge end voltage in an arithmetic unit (3) of the electronic device (1).

4. Method according to one of the preceding claims, wherein a number of operating states ($B_n$) is predefined.

5. Method according to Claim 4, wherein a number of activations of the predefined operating states ($B_n$) is recorded.

6. Method according to Claim 4 or 5, wherein the mean discharge current ($I_m$) is determined as follows:

    - determining the number of activations of predefined operating states ($B_n$) of the electronic device (1),
    - determining an associated operating duration ($D_{Bn}$) of the activated operating state ($B_n$) in each case,
    - determining a discharge current ($I_{Bn}$) representing the activated operating state ($B_n$) in each case,
    - determining a frequency distribution (HV1) of the activated operating states ($B_n$) on the basis of the ascertained number of activations,
    - determining a mean discharge current ($I_m$) on the basis of the frequency distribution (HV1) of the activated operating states ($B_n$) and the ascertained operating durations ($D_{Bn}$) and the discharge currents ($I_{Bn}$) of the activated operating states ($B_n$).

7. Method according to one of the preceding claims, wherein the self-discharge ($S_a$) per predefined period of time is ascertained as a function of the battery temperature ($T_{Bn}$) based on a frequency distribution (HV2) of the battery temperatures ($T_{Bn}$) and/or a frequency distribution (HV3) of battery temperature intervals ($T_{In}$).

8. Method according to one of the preceding claims, wherein the self-discharge ($S_a$) per predefined period of time is determined as a function of the mean battery temperature in accordance with the Arrhenius equation:

$$S_a = A \cdot e^{-\left(\frac{E_A}{R \cdot T_m}\right)}$$

where $S_a$ = self-discharge per predefined period of time, a = predefined period of time, A = pre-exponential factor, $E_A$ = activation energy, R = universal gas constant, $T_m$ = mean battery temperature.

9. Method according to Claim 7 or 8, wherein the mean battery temperature is determined on the basis of a frequency distribution (HV2) of battery temperatures ($T_{Bn}$) and/or a frequency distribution (HV3) of battery temperature intervals ($T_{In}$).

10. Method according to one of Claims 7 to 9, wherein the mean battery temperature ($T_m$) is determined as follows:

    - determining battery temperatures ($T_{Bn}$) or battery temperature intervals ($T_{In}$),
    - determining a frequency distribution (HV2) of the battery temperatures ($T_{Bn}$) and/or a frequency distribution (HV3) of battery temperature intervals ($T_{In}$),
    - determining a mean battery temperature ($T_m$) on the basis of the frequency distribution (HV2) of the battery temperatures ($T_{Bn}$) and/or the frequency distribution (HV3) of the battery temperature intervals ($T_{In}$).

11. Method according to one of the preceding claims, wherein the determination of one or more operating states ($B_n$) involves determining a measuring mode, a calculating mode, a storage mode, a communication mode, a transmission mode, an idle mode, a temperature mode and/or an installation mode of the electronic device (1), and/or a use mode of the electronic device (1) at a location.

12. Computer program product comprising program code parts for carrying out a method according to one of Claims 1 to 11 when the computer program product is executed by an arithmetic unit (3) of the electronic device (1).

13. Electronic device (1) having a prediction system (8) for determining the remaining life (t_R) of a battery (2) of the electronic device (1), in particular of a consumption meter, wherein the prediction system (8) comprises a computer program product according to Claim 12 which is executed by the arithmetic unit (3).

**Revendications**

1. Procédé de détermination de la durée de vie restante (t_R) d'une batterie (2) d'un appareil électronique (1), en particulier d'un appareil de mesure (1) à consommation électrique variable,

   la durée de vie restante (t_R) étant déterminée, sur la base d'une capacité amovible (c_{eb}) de la batterie (2), d'une durée spécifiée (a), d'une autodécharge (Sa) de la batterie (2) par durée spécifiée (a) et d'un courant de décharge moyen (I_m) de la batterie (2), de la manière suivante :

$$t_R = \frac{c_{eb}}{I_m} \cdot (1 - S_a)^{\frac{t_R}{a}}$$

   avec C_{eb} = capacité amovible, Sa = autodécharge par durée spécifiée, par exemple un an, a = durée spécifiée (par exemple un an ou un mois), I_m = courant de décharge moyen, t_R = durée de vie restante,
   le courant de décharge moyen (I_m) de la batterie (2) étant déterminé sur la base d'une distribution de fréquence (HV1) d'un certain nombre d'états de fonctionnement (B_n).

2. Procédé selon la revendication 1, la capacité amovible C_{eb} étant spécifiée comme valeur fixe et/ou une valeur en mémoire étant utilisée.

3. Procédé selon la revendication 1, la capacité amovible C_{eb} étant déterminée sur la base d'une famille de caractéristiques en fonction du courant de décharge moyen (I_m), de la température moyenne T_m et de la tension de décharge finale dans une unité de calcul (3) de l'appareil électronique (1).

4. Procédé selon l'une des revendications précédentes, un certain nombre d'états de fonctionnement (B_n) étant spécifié.

5. Procédé selon la revendication 4, un certain nombre d'activations des états de fonctionnement spécifiés (B_n) étant détecté.

6. Procédé selon la revendication 4 ou 5, le courant de décharge moyen (I_m) étant déterminé de la manière suivante :

   - déterminer le nombre d'activations d'états de fonctionnement spécifiés (B_n) de l'appareil électronique (1),
   - déterminer une durée de fonctionnement associée (D_{Bn}) de l'état de fonctionnement (B_n) respectivement activé,
   - déterminer un courant de décharge (I_{Bn}) représentant l'état de fonctionnement respectivement activé (B_n),
   - déterminer une distribution de fréquence (HV1) des états de fonctionnement activés (B_n) sur la base du nombre d'activations déterminé,
   - déterminer un courant de décharge moyen (I_m) sur la base de la distribution de fréquence (HV1) des états de fonctionnement activés (B_n) et des durées de fonctionnement déterminées (D_{Bn}) et des courants de décharge (I_{Bn}) des états de fonctionnement activés (B_n).

7. Procédé selon l'une des revendications précédentes, l'autodécharge (S_a) par durée spécifiée étant déterminée en fonction de la température de batterie (T_{Bn}) sur la base d'une distribution de fréquence (HV2) des températures de batterie (T_{Bn}) et/ou d'une distribution de fréquence (HV3) d'intervalles de température de batterie (T_{In}).

8. Procédé selon l'une des revendications précédentes, l'autodécharge (Sa) par durée spécifiée étant déterminée en fonction de la température de batterie moyenne selon l'équation d'Arrhenius :

$$S_a = A \cdot e^{-\left(\frac{E_A}{R \cdot T_m}\right)}$$

avec $S_a$ = autodécharge par durée spécifiée, a = durée spécifiée, A = facteur pré-exponentiel, $E_A$ = énergie d'activation, R = constante universelle des gaz, $T_m$ = température de batterie moyenne.

**9.** Procédé selon la revendication 7 ou 8, la température de batterie moyenne étant déterminée sur la base d'une distribution de fréquence (HV2) des températures de batterie ($T_{Bn}$) et/ou d'une distribution de fréquence (HV3) d'intervalles de température de batterie ($T_{In}$).

**10.** Procédé selon l'une des revendications 7 à 9, la température de batterie moyenne ($T_m$) étant déterminée de la manière suivante :

- déterminer des températures de batterie ($T_{Bn}$) ou des intervalles de température de batterie ($T_{In}$),
- déterminer une distribution de fréquence (HV2) des températures de batterie ($T_{Bn}$) et/ou une distribution de fréquence (HV3) d'intervalles de température de batterie ($T_{In}$),
- déterminer une température de batterie moyenne ($T_m$) sur la base de la distribution de fréquence (HV2) des températures de batterie ($T_{Bn}$) et/ou de la distribution de fréquence (HV3) des intervalles de température de batterie ($T_{In}$).

**11.** Procédé selon l'une des revendications précédentes, la détermination d'un ou plusieurs états de fonctionnement ($B_n$) comprenant la détermination d'un mode de mesure, d'un mode de calcul, d'un mode de mémorisation, d'un mode de communication, d'un mode d'émission, d'un mode de repos, d'un mode de température et/ou d'un mode d'installation de l'appareil électronique (1), et/ou d'un mode d'application de l'appareil électronique (1) sur un site.

**12.** Produit programme d'ordinateur comprenant des parties de code de programme destinées à mettre en oeuvre un procédé selon l'une des revendications 1 à 11, lorsque le produit programme d'ordinateur est exécuté par une unité de calcul (3) de l'appareil électronique (1).

**13.** Appareil électronique (1) comprenant un système de pronostic (8) destiné à déterminer la durée de vie restante ($t_R$) d'une batterie (2) de l'appareil électronique (1), notamment un compteur de consommation, le système de pronostic (8) comprenant un produit programme d'ordinateur selon la revendication 12, qui est exécuté par l'unité de calcul (3).

FIG 1

FIG 2

FIG 3

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011113828 A1
- DE 102001010985 A1
- DE 102018126673 A1
- WO 2008082288 A1
- US 11073567 B2
- DE 10158029 A1